# NEUE EUROPÄISCHE PATENTSCHRIFT

(11) **EP 0 228 019 B2**
(45) Veröffentlichungstag und Bekanntmachung des Hinweises auf die Entscheidung über den Einspruch: **07.12.1994**
(45) Hinweis auf die Patenterteilung: 28.03.1990
(21) Anmeldenummer: 86117485.2
(22) Anmeldetag: 16.12.1986
(51) Int. Cl.: H03K 17/95

(54) **Berührungsloser Näherungsschalter**
Proximity switch operating without contact
Commutateur de proximité fonctionnant sans contact

(30) Priorität: 28.12.1985 DE 3546245
(43) Veröffentlichungstag der Anmeldung: 08.07.1987
(73) Patentinhaber: Link, Walter, Dr.-Ing., D-71277 Rutesheim (DE)
(72) Erfinder: Link, Walter, Dr.-Ing., D-71277 Rutesheim (DE)
(74) Vertreter: Patentanwälte Bartels und Partner

(56) Entgegenhaltungen:
- DE-A- 3 204 405
- DE-A- 3 318 900
- DE-C- 2 119 507
- Datenblatt 367 110 der Fa. Rohde und Schwarz, München, für digitalesGütefaktormessgerät, Typ QDM, Nr. 109 3184.02, 1973

## Beschreibung

Die Erfindung betrifft einen berührungslosen Näherungsschalter, welcher die Merkmale des Oberbegriffs des Anspruches 1 aufweist.

Es ist bei Näherungsschaltern dieser Art bekannt (DE-OS 1 762 565 und DE-PS 3 440 538), eine impulsförmige Anregung des Schwingkreises vorzusehen, um den Näherungsschalter auch für größere Schaltentfernungen einsetzen zu können oder den Strombedarf sowie den Schaltungsaufwand zu reduzieren und die Funktionssicherheit zu erhöhen. Bei einem anderen bekannten Näherungsschalter der eingangs genannten Art (DE-OS 3 318 900) erfolgt die impulsförmige Anregung des Schwingkreises zum Zwecke der Verminderung des Energieverbrauchs im Vergleich zu einem ständig schwingenden, von einem Hochfrequenz-Oszillator angeregten Schwingkreis durch periodische Impulse, deren zeitlicher Abstand voneinander größer als die maxi maieAuskiingzeit der Schwingungen des Schwingungskreises. Als Kriterium für die Auslösung eines Schaltvorgangs dient der Mittelwert der gleichgerichteten Schwingungen des Schwingkreises oder die Amplitude der abklingenden Schwingung zu einem bestimmten Zeitpunkt nach dem Anstoß. Die Genauigkeit und Reproduzierbarkeit der Schaltposition des den Schaltvorgang auslösenden Schaltelementes ist bei einem derartigen Näherungsschalter auch nicht größer als bei den üblicherweise verwendeten, berührungslosen Näherungsschaltem, die darauf beruhen, daß die Annäherung eines magnetisch und/oder elektrisch leitenden Teilchens oder Schaltelementes über das magnetische Feld die Schwingbedingung des Hochfrequenz-Oszillators derart beeinträchtigt oder eine Regelgröße zur Aufrechterhaltung der Hochfrequenzschwingung derart beeinflußt, daß ein Schaltsignal erfolgt. Dies beruht darauf, daß aufgrund der bei den gewünschten großen Abständen geringen Signaländerungen eine zeitliche Integration notwendig ist, andererseits, vor allem durch die Temperaturabhängigkeit der Schaltungskomponenten, die erreichbare Genauigkeit auf einen Wert begrenzt ist, der immer wieder die Einsatzmöglichkeit eines solchen Näherungsschalters ausschließt. Letzteres ist teilweise auch darauf zurückzuführen, daß die bekannten Näherungsschalter sich nicht im ausreichenden Maße miniaturisieren lassen.

Dies gilt auch für einen anderen bekannten Näherungsschalter (DE-OS 32 04 405), bei dem außer einem Oszillator, dessen Frequenz von einem sich annähernden Schaltelement veränderbar ist, ein zweiter Oszillator mit unveränderlicher Frequenz vorhanden ist, wobei mittels zweier Zähler die beiden Frequenzen ermittelt und mittels eines Vergleichers verglichen werden, welcher bei einer vorgegebenen Differenz ein Schaltsignal auslöst. Die von der Position des Schaltelementes abhängige Induktivität- und Frequenzänderung ist hier ebenfalls so gering, daß der Frequenzvergleich zu keiner besseren Genauigkeit und ReproduzierbarkeitderSchaltbedingungenführt.

Mit einem anderen bekannten Näherungsschalter (DE-OS 31 31 490) ist es möglich,entweder zwischen einem definierten Schaltelement, zum Beispiel einem Steuernocken in einem Nutfeld, und der Annäherung eines kein Schaltelement darstellenden Metallteilchens, beispielsweise eines Spanes, zu unterscheiden oder sogar eine Unterscheidung zwischen mehreren Schaltelementen, zum Beispiel unterschiedlichen Steuernocken in einem einzigen Nutenfeld eine Unterscheidung treffen zu können. Im übrigen, beispielsweise hinsichtlich der Genauigkeit und Reproduzierbarkeit der Schaltbedingungen, aber auch hinsichtlich der Miniaturisierbarkeit, ist dieser Näherungsschalter den anderen bekannten Näherungsschaltern nicht überlegen.

Den Vorteil, die Größe des Abstandes des Schaltelementes von der Sensorfläche des Näherungsschalters numerisch erfassen zu können, weist ein bekannter berührungsloser Näherungsschalter (DE-C 2119 507) der im Oberbegriff des Anspruches 1 definierten Gattung auf. Bei diesem Näherungsschalter wird mit einer vorgegebenen Taktfrequenz der Schwingkreis sprungförmig angeregt. Ein durch einen Schmitt-Trigger gebildeter Komparator vergleicht die Amplituden der Schwingkreisspannung mit einem Schwellenwert und erzeugt für jede über diesem Schwellenwert liegende Amplitude einen Rechteckimpuls. Die Anzahl dieser Impulse wird für jede Sprungantwort des Schwingkreises von einem nachgeschalteten Zähler ermittelt. Da die Sprungantwort umso stärker gedämpft ist, je geringer der Abstand des Schaltelementes von der Sensorfläche des Näherungsschalters ist, kann aus der Zahl der Impulse pro Sprungantwort der Abstand des Schaltelementes von der Sensorfläche ermittelt werden.

Der Erfindung liegt die Aufgabe zugrunde, einen berührungslosen Näherungsschalter zu schaffen, der noch weiterreichende Einsatzmöglichkeiten als die vorstehend erwähnten, bekannten Näherungsschalter hat. Diese Aufgabe löst ein Näherungsschalter mit den Merkmalen des Anspruches 1.

Dank des wie der erste Zähler an den Ausgang des Komparators angeschlossenen zweiten Zählers, welcher eine der Eigenfrequenz der Sprungantwort entsprechende digitale Größe bildet, können bei dem erfindungsgemäßen Näherungsschalter bei derAuswertung der Sprungantwort auch diejenigen Eigenvorgänge erfaßt werden, welche die Identität des Schaltelementes charakterisieren, so daß eine kombinierte Positions- und Identitätserkennung möglich ist, und zwar mit einer hohen Zuverlässigkeit.

Mit Ausnahme der Spulen und des Kondensators werden für den erfindungsgemäßen Näherungsschalter nur digitale Schaltungskomponenten benötigt, weshalb sich eine Miniaturisierung, insbesondere in Form einer integrierten Schaltung, besonders einfach und kostengünsting durchführen läßt. Die entscheidende analoge Größe, nämlich der Referenzspannungspegel, kann mit Hilfe eines einfachen Spannungsteilers temperaturunabhängig und außerhalb der integrierten Schaltung festgelegt werden. Dank der digitalen Signalauswertung istdie Zuverlässigkeit, Genauigkeit und Reproduzierbarkeit hoch, wodurch sich auch relativ große Schaltelementabstände erreichen lassen. Die sprungförmige Anregung des Schwingkreises trägt dazu bei, die Schaltung besonders einfach ausbilden zu können. Die Amplitude der Sprungantwort, die Abklingzeitkonstante, die Anzahl der Nachschwingungen und die Eigenfrequenz der Sprungantwort sind Größen, von denen auch mehrere gleichzeitig oder zeitlich verschachtelt durch die aktiven und passiven Eigenschaften des Schaltelementes beeinflußt sein können.

Eine weiterere Erhöhung der Genauigkeit läßt sich mit einer Ausführungsform gemäß Anspruch 2 erreichen. Weitere vorteilhafte Ausgestaltungs- und Weiterbildungsmöglichkeiten der erfindungsgemäßen Lösung sind Gegenstand der übrigen abhängigen Ansprüche.

Beispielsweise kann der Schwingkreis statt im Näherungsschalter in dem diesem zugeordneten Schaltelement angeordnet sein. Sowohl in diesem Falle als auch dann, wenn im Schaltelement nur eine Spule angeordnet ist, kann das Schaltelement ferner eine integrierte Schaltung enthalten, welche über die induktive Kopplung die Sprungantwort aktiv beeinflußt. Diese integrierte Schaltung kann aus einem Mikrorechner und einem elektronisch programmierbaren Festwertspeicher bestehen. Für die Versorgung der integrierten Schaltung mit der erforderlichen Betriebsspannung, kann im Schaltelement eine induktiv an den Annäherungsschalter ankoppelbare Spule vorgesehen sein, die gewissermaßen die Sekundärwicklung eines Transformators bildet.

Die erfindungsgemäße Lösung stellt einen inkrementalen Näherungsschalter dar, weshalb nicht nur eine inkrementale Positionsermittlung des Sensors möglich ist, sondern auch eine Unterscheidung verschiedener Zonen. Der Komparator kann ferner so ausgebildet sein, daß er beim Ubergang von einer zur nächsten Zahl von Ausgangsimpulsen eine analoge Ausgangsgröße liefert, womit zum Beispiel eine stetige Positionsregelung in den diesen Ausgangsimpulsen zugeordneten Positionen möglich ist.

Die Auswerteschaltung kann, vorzugsweise mittels eines Mikrorechners, mit Hilfe der Extrempositionen des Sensors, d.h. den Abstandswerten 0 und unendlich, eine oder mehrere Korrekturgrößen ermitteln, welche unabhängig von dem absoluten Wert der durch den Sensor beeinflußten Größen ein relatives Kriterium für eine oder mehrere Positionen liefern. Enthält die Auswertschaltung einen Digitalspeicher, dann können die erfaßten Größen über eine beliebige tabellarische Zuordnung korrigiert werden und zum Beispiel bezüglich der Positionsabhängigkeit linearisiert werden. Ferner kann für alle erfaßbaren, diskreten Abstandspositionen ein jeweils unterschiedliches Hysteresverhalten bezüglich der Wegabhängigkeit digital programmiert werden.

Im folgenden ist die Erfindung anhand von in der Zeichnung dargestellten Ausführungsbeispielen im einzelnen erläutert. Es zeigen
Fig. 1 ein Blockschaltbild eines ersten Ausführungsbeispiels,
Fig. 2 den Impulsfahrplan des ersten Ausführungsbeispiels,
Fig. 3 ein Blockschaltbild eines zweiten Ausführungsbeispiels.

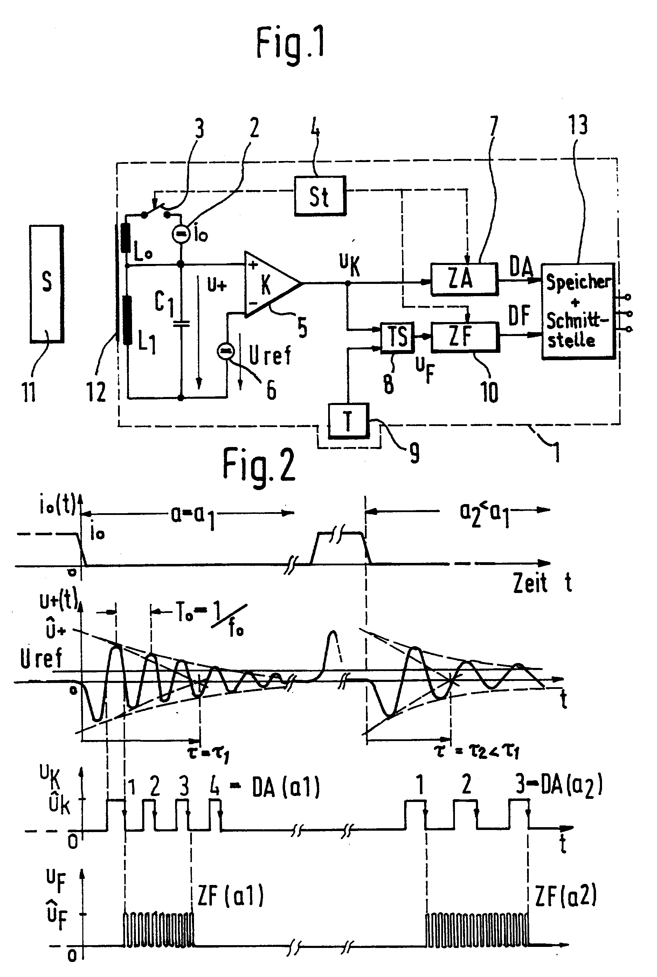

Das nicht dargestellte Gehäuse eines berührungslosen, inkrementalen Näherungsschalters enthält eine Erregungs- und Auswertestufe 1 mit einem Schwingkreis hoher Güte. Dieser Schwingkreis besteht aus einer Spule L1 und einem Kondensator C1. Mit der Spule L1 ist eine Anregungsspule LO gekoppelt, in deren Stromkreis eine Gleichstromquelle 2 und ein Halbleiterschalter 3 liegen, der den durch die Anregungsspule LO fließenden Strom iₒ in einer so kurzen Zeit zu unterbrechen vermag, daß eine sprungförmige Stromänderung erreicht wird, wie dies das Strom-Zeit-Diagramm in Fig. 2 zeigt. Selbstverständlich wäre es auch möglich, einen Teil der Spule L1 oder die gesamte Spule L1 als Anregungsspule zu verwenden und den Strom der Gleichstromquelle in den Schwingkreis einzuspeisen. Eine Steuerschaltung 4 bewirkt den Übergang des Halbleiterschalters 3 vom leitenden in den nicht leitenden Zustand und umgekehrt.

Der eine Pol der Spule L1 und des Kondensators C1 sind mit dem einen Eingang eines Komparators 5 verbunden, an dessen anderen Eingang der eine Pol einer Referenzspannungsquelle 6 angeschlossen ist, die einen präzise einstellbaren Referenzspannungspegel Uᵣₐₜ liefert. Der andere Pol der Referenzpannungsquelle 6 ist mit dem anderen Pol der Spule L1 und des Kondensators C1 verbunden. Der Komparator 5 ist daher in der Lage, festzustellen, ob der Momentanwert der Schwingkreisspannung u+ über dem Referenzspannungspegel Uᵣₐₜ, auf diesem Pegel oder unter diesem Pegel liegt. Im Ausführungsbeispiel ist der Komparator 5 so ausgebildet, daß an seinem Ausgang immer dann eine Spannung uₖ mit konstantem Pegel auftritt, wenn die Schwingkreisspannung den Referenzspannungspegel übersteigt. Die Ausgangsgrößen des Komparators 5 sind daher Impulse.

Diese Impulse werden, wie Fig. 1 zeigt, einem ersten Zähler 7 sowie einer Torschaltung 8 zugeführt, an deren anderem Eingang die von einem quarzstabilen Taktgenerator 9 erzeugten Impulse anliegen. Die Wiederholfrequenz der Impulse des Taktgenerators 9 ist wesentlich größer als diejenige der Impulse des Komparators 5. An den Ausgang der Torschaltung 8 ist der Eingang eines zweiten Zählers 10 angeschlossen, welcher aufgrund der Anzahl von vom Taktgenerator 9 gelieferten Zählimpulse die Frequenz der Schwingkreisspannung u+ als digitale Größe ermittelt. Im Ausführungsbeispiel bewirkt die Steuerschaltung 4, welche die beiden Zähler 7 und 10 ansteuert, daß nicht die Zahl der Zählimpulse zwischen zwei aufeinanderfolgenden Impulsen des Komparators ermittelt wird, sondern zwischen einem Impuls des Komparators und dessen übemächstem Impuls. Die Zählzeit könnte sich aber auch über mehr als zwei Impulse des Komparators erstrecken, um die Frequenz noch genauer ermitteln zu können.

Als Schaltelement, 11 auf den der Näherungsschalteranspricht, ist imAusführungsbeispiel ein Körper aus einem magnetisch und elektrisch leitenden Metall vorgesehen. Solange der Abstand des Schaltelementes 11 von einer Sensorfläche 12 des Schwingkreises so groß ist, daß das Schaltelement 11 außerhalb des Magnetfeldes der Spuie L1 und der Erregungsspule LO liegt, hat die sprungförmige Anregung des Schwingkreises beim Abschalten des durch die Anregungsspule LO fließenden Stromes zur Folge, daß die Schwingkreisspannung mit ihrer maximalen Frequenz und ihrer maximalen Abklingzeitkonstante abklingt. Befindet sich hingegen das Schaltelement im magnetischen Feld der Spule L1 des Schwingkreises, dann wird die Abklingzeitkonstante τ und die Frequenz der Schwingkreisspannung umso kleiner, je geringer der Abstand a ist, wie dies in Fig. 2 die Spannung/Zeit-Diagramme für die Schwingkreisspannung u+ und die Ausgangsspannung des Komparators 5 zeigen. Hat beispielsweise der Abstand a des Schaltelementes 11 von der Sensorfläche 12 den Wert a₁, dann hat die sprungförmige Unterbrechung des Stromes i in der Anregungsspule LO zur Folge, daß die Schwingkreisspannung u+ den im Spannungs/Zeit-Diagramm an erster Stelle dargestellten zeitlichen Verlauf hat. Die Schwingkreisspannung überschreitet bei diesem Abklingvorgang viermal den positiven Referenzspannungspegel U_{ref} in positiver Richtung, weshalb am Ausgang des Komparators 5 vier Impulse abnehmender Breite, aber konstanter Frequenz auftreten. Diese vom ersten Zähler 7 ermittelte Anzahl von Impulsen DA stellt eine erste digitale Größe dar, die kennzeichnend ist für die Größe des Abstandes a zwischen Schaltelement 11 und Sensorfläche 12 sowie für die Eigenschaft des Schaltelementes 11, im Ausführungsbeispiel also für die durch es bewirkte Verminderung der Güte des Schwingkreises. Die vom zweiten Zähler 10 ermittelte Anzahl von Zählimpulsen DF zwischen den abfallenden Flanken des ersten und dritten Impulses des Komparators 5 kennzeichnet die Eigenfrequenz der Schwingkreisspannung U+, die man wegen der sprungförmigen Anregung als Sprungantwort bezeichnet. Auch die vom zweiten Zähler 10 gelieferte zweite digitale Größe DF ist charakteristisch für den Abstand al und die Eigenschaften des Schaltelementes 11.

Zwar ist die Genauigkeit und Wiederholbarkeit der von der Erregungs- und Auswertstufe 1 gelieferten Ergebnisse besser als bei den bekannten Näherungsschaltem. Man kann jedoch zu noch besseren Ergebnissen kommen, wenn man den Schwingkreis mehrmals nach einander sprungförmig anregt und die Impulszählungen wiederholt, wobei die Steuerschaltung 4 die Möglichkeit bietet, die Zahl der Wiederholungen festzulegen.

Hat der Abstand a zwischen dem Schaltelement 11 und der Sensorfläche 12 den im Vergleich zu Wert a₁ kleineren a, dann sind die Abklingzeitkonstante τ und die Frequenz der Sprungantwort kleiner als bei dem Wert a₁, wie dies das Spannungs/Zeit-Diagramm in Fig. 2 zeigt. Am Ausgang des Komparators 5 treten dann beispielsweise nur noch drei Impulse auf. Da auch die Frequenz der Sprungantwort geringer ist, ist die vom zweiten Zähler 10 ermittelte Anzahl von Zählimpulsen größer.

Im Ausführungsbeispiel wird sowohl die vom ersten Zähler ermittelte digitale Größe DAals auch die vom zweiten Zähler 10 ermittelte digitale Größe DF, die beide charakteristisch für den Abstand zwischen dem Schaltelement 11 und der Sensorfläche 12 sowie den Eigenschaften des Schaltelementes sind, einer nachfolgenden Stufe 13 eingegeben, welche einen Speicher und eine Schnittstelle enthält. Durch einen Vergleich der Zählergebnisse mit tabellarisch im Speicher abgelegten Funktionen werden programmabhängig diejenigen Signale erzeugt, welche der Näherungsschalter abhängig vom Abstand zwischen Schaltelement 11 und Sensorfläche 12 und/odervon den Eigenschaften des Schaltelementes zu geben hat. Für alle erfaßbaren diskreten Abstandswerte kann ein bezüglich der Weg- oderAbstandsabhängigkeit digital programmiertes, jeweils unterschiedliches Hysteresverhalten vorgesehen sein, indem bei einem bestimmten Wert DA 1 der vom Zähler gezählten Größe DAdie zugehörige Schaltfunktion auf EIN und bei einem anderen, von Wert DA 1 verschiedenen Wert DA 2 die Schaltfunktion auf AUS gesetzt wird.

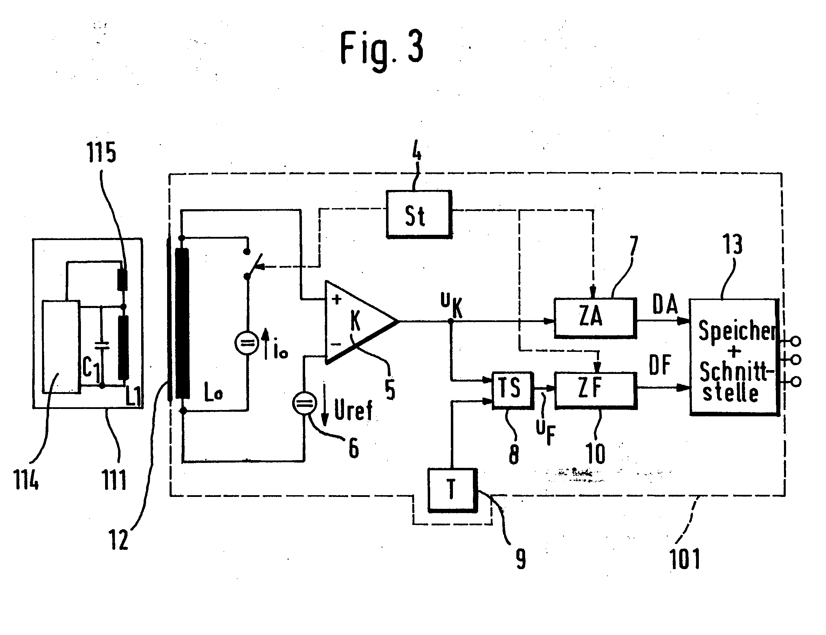

Das in Fig. 3 dargestellte Ausführungsbeispiel unterscheidet sich von demjenigen gemäß den Fig. 1 und 2 nur dadurch, daß seine Erregungs- und Auswertestufe 101 keinen Schwingkreis, sondern nurdie Anregungsspule LO enthält, deren die Sprungantwort darstellende Spannung vom Komparator mit dem Referenzspannungspegel verglichen wird.

Der aus der Spule L1 zu dem Kondensator C1 bestehenden Schwingkreis ist im Schaltelement 111 angeordnet. Befindet sich das Schaltelement 111 im Magneffeld der Anregungsspule L0, dann führt auch hier die sprungförmige Unterbrechung des durch die Spule LO fließenden Stromes zu einem Anstoß des Schwingkreises. Die magnetische Kopplung zwischen der Spule L1 des Schwingkreises und der Anregungsspule LO führt aber andererseits auch dazu, daß in derAnregungsspule LO eine der Schwingkreisspannung entsprechende Spannung induziert wird, die als Sprungantwort von der Erregungs- und Auswertestufe 101 ausgewertet wird. Da die magnetische Kopplung zwischen der Anregungsspule LO und der Spule L1 des Schwingkreises abhängig vom Abstand zwischen dem Schaltelement 111 zur der Sensorfläche 12 ist, besteht auch bei diesem Ausführungsbeispiel eine Abhängigkeit zwischen den von den beiden Zählern ermittelten digitalen Größen und dem Abstand des Schaltelementes 111 sowie dessen Eigenschaften.

Im Ausführungsbeispiel ist der Schwingkreis an eine ebenfalls im Schaltelement 111 untergebrachte integrierte Schaltung 114 angeschlossen, deren Betriebsspannung von einer an die übrigen Spulen magnetisch angekoppelten Hilfsspule 115 geliefert wird. Mit Hilfe der integrierten Schaltung 114 können die Sprungantwort des Schaltelementes 111 aktiv beeinflußt und die Eigenschaften des Schaltelementes 111 in einem weiten Bereich variiert werden. Beispielsweise kann die Spule L 1 nach einer bestimmten Anzahl von Ausklingvorgängen kurzgeschlossen werden. Die integrierte Schaltung 114 enthält einen elektrisch programmierbaren und löschbaren Festwertspeicher, in dem eine charakteristische Schaltfunktion zur Identifizierung des Schaltelementzustandes abgespeichert ist.

## Patentansprüche

1. Berührungsloser Näherungsschalter mit
a) einem eine sprungförmige Anregung aufweisenden Schwingkreis (L1, C1),
b) wenigstens einem Schaltelement (11;111), welches den zeitlichen Verlauf wenigstens einer Sprungantwort des Schwingkreises (L1, C1) in Abhängigkeit von seinem Abstand von einer Sensorfläche (12) des Schalters beeinflußt,
c) einer Auswerteschaltung (1; 101), welche von wenigstens einer Sprungantwort des Schwingkreises (L1, C1) auf eine derartige Anregung zumindest eine für den zeitlichen Verlauf der abklingenden Schwingung kennzeichnende Größe erfaßt,
d) einer wenigstens einen Referenzspannungspegel (U_{ref}) erzeugenden Referenzspannungsquelle (6),
e) wenigstens einem Komparator (5), der die Amplitude der Sprungantwort mit dem zugeordneten Referenzspannungspegel (U_{ref}) vergleicht,
f) wenigstens einem Zähler (7), welcher zumindest innerhalb eines Teils derAusklingzeit der Sprungantwort die Anzahl (DA) derjenigen Halbwellen der Sprungantwort zählt, deren Spitzenwert den zugeordneten Referenzspannungspegel (U_{ref}) über- oder unterschreitet, dadurch gekennzeichnet, daß
g) wenigstens ein wie der erste Zähler (7) an den Ausgang des Komparators (5) angeschlossener zweiterZähier (10) vorgesehen ist, welcher eine der Eigenfrequenz der Sprungantwort entsprechende digitale Größe bildet, und
h) die der Eigenfrequenz der Sprungantwort entsprechende digitale Größe der Auswerteschaltung (1; 101) zusammen mit der vom ersten Zähler (7) gebildeten, der Ausklingzeit der Sprungantwort entsprechenden digitalen Größe zur gemeinsamen Auswertung zugeführt wird.

2. Näherungsschalter nach Anspruch 1, dadurch gekennzeichnet, daß der zweite Zähler (10) an den Ausgang einer Torschaltung (8) angeschlossen ist, deren beide Eingänge mit dem Ausgang des Komparators (5) bzw. einem frequenzstabilen Taktgenerator (9) verbunden sind, dessen Wiederholfrequenz größer ist als die Eigenfrequenz der Sprungantwort.

3. Näherungsschalter nach Anspruch 1 oder 2, gekennzeichnet durch eine Steuerstufe (4) für eine sich wiederholende sprungförmige Anregung des Schwingkreises und eine Festlegung der Zählvorgänge des Zählers (7, 10) auf eine bestimmte Anzahl von Sprungantworten.

4. Näherungsschalter nach einem der Ansprüche 1 bis 3, dadurch gekennzeichnet, daß das Schaltelement (11) aus einem magnetisch und elektrisch leitenden Metallplättchen besteht, welches die Eigenfrequenz (fₒ) und die Abklingzeitkonstante (_{T}) des Sprungantwort beeinflußt.

5. Näherungsschalter nach einem der Ansprüche 1 bis 3, dadurch gekennzeichnet, daß das Schaltelement aus einem elektrisch, nicht aber magnetisch leitenden Material besteht, welches im wesentlichen nur die Abklingzeitkonstante (_{T}) der Sprungantwort beeinflußt.

6. Näherungsschalter nach einem der Ansprüche 1 bis 3, dadurch gekennzeichnet, daß das Schaltelement aus Ferritmaterial besteht und im wesentlichen nur die Eigenfrequenz (fₒ) der Sprungantwort beeinflußt.

7. Näherungsschalter nach einem der Ansprüche 1 bis 3, dadurch gekennzeichnet, daß der Schwingkreis (L1, C1) im Schaltelement (111) angeordnet ist und für die Anregung sowie die Erfassung der Sprungantwort eine Spule (L0) innerhalb der Erregungs- und Auswertestufe (101) vorgesehen ist.

8. Näherungsschalter nach einem der Ansprüche 1 bis 7, gekennzeichnet durch einen digitalen Speicher der Erregungs- und Auswertstufe (1; 101) für eine Korrektur der ermittelten digitalen Größen über eine beliebige tabellarische Zuordnung im Speicher.

9. Näherungsschalter nach einem der Ansprüche 1 bis 8, gekennzeichnet durch ein bezüglich der Wegabhängigkeit digital programmiertes, jeweils unterschiedliches Hysteresverhalten für alle erfaßbaren diskreten Abstandspositionen, indem bei einer bestimmten, vom Zähler (7, 107) gezählten Anzahl (DA 1) von Halbwellen die betreffende Schaltfunktion auf EIN, und bei einem anderen, von der genannten Anzahl (DA 1) verschiedenen Anzahl (DA 2) die Schaltfunktion auf AUS gesetzt wird.

10. Näherungsschalter nach Anspruch 7, dadurch gekennzeichnet, daß eine Spule (115) des Schaltelementes (111) über eine induktive Koppelung zur Spule (L0) der Erregungs- und Auswertestufe die Betriebsspannung für eine integrierte Schaltung (114) im Schaltelement (111) liefert und die Schaltung (114) die Sprungantwort des Schaltelementes (111) aktiv beeinflußt, indem sie vorzugsweise die Spule (L1) nach einer bestimmten Anzahl von Ausklingvorgängen kurzschließt.

11. Näherungsschalter nach Anspruch 10, dadurch gekennzeichnet, daß die Schaltung (114) einen elektrisch programmier- und löschbaren Festwertspeicher enthält, in dem eine charakteristische Schaltfunktion zur Identifizierung des Schaltelementzustandes abspeicherbar ist.

## Claims

1. Proximity switch operating without contact with:
a) an oscillating circuit (L1, C1) comprising a jump-like energisation;
b) at least one circuit component (11; 111) which influences the temporal course of at least one jump response of the oscillating circuit (L1, C1) in dependence upon its distance from a sensor surface (12) of the switch;
c) an evaluating circuit (1; 101) which determines at least one value which characterises the temporal course of the fading oscillation from at least one jump response of the oscillating circuit (L1; C1) when an energisation of this type occurs;
d) a reference voltage source (6) producing at least one reference voltage level (U_{ref});
e) at least one comparator (5) which compares the amplitude of the jump response with the associated reference voltage level (U_{ref});
f) at least one counter (7) which counts the number (DA) of those half-waves of the jump response, the peak value of which is above or below the associated reference voltage level (Uᵣ,_{f}), at least within part of the fade time of the jump response, characterised in that
g) at least one second counter (10) is provided which, like the first counter (7), is connected to the output of the comparator (5) and which forms a digital value corresponding to the inherent frequency of the jump response; and
h) the digital value corresponding to the inherent frequency of the jump response together with the digital value formed by the first counter (7) and corresponding to the fade time of the jump response is delivered to the evaluation circuit (1; 101) for common evaluation.

2. Proximity switch as claimed in Claim 1, characterised in that the second counter (10) is connected to the output of a gate switch (8), both inputs of which are connected to the output of the comparator (5) or a frequency-stable pulse generator (9), the recurrence frequency of which is higher than the inherent frequency of the jump response.

3. Proximity switch as claimed in Claim 1 or 2, characterised by a control stage (4) for a recurring, jump-like energising of the oscillating circuit and a setting of the counting procedures of the counters (7, 10) to a given number of jump responses.

4. Proximity switch as claimed in one of Claims 1 to 3, characterised in that the circuit component (11) consists of a magnetically and electrically conductive small metal plate which influences the inherent frequency (fₒ) and the fade time constant (i) of the jump response.

5. Proximity switch as claimed in one of Claims 1 to 3, characterised in that the circuit component consists of a material which is electrically but not magnetically conductive and essentially influences only the fade time constant (i) of the jump response.

6. Proximity switch as claimed in one of Claims 1 to 3, characterised in that the circuit component consists of ferrite material and essentially influences only the inherent frequency (fₒ) of the jump response.

7. Proximity switch as claimed in one of Claims 1 to 3, characterised in that the oscillating circuit (L1, C1) is disposed in the circuit component (111) and a coil (LO) is provided within the energising and evaluating stage (101) for energising and determining the jump response.

8. Proximity switch as claimed in one of Claims 1 to 7, characterised by a digital memory of the energising and evaluating stage (1; 101) for correcting the digital values determined by means of any interpretation in tabular form in the memory.

9. Proximity switch as claimed in one of Claims 1 to 8, characterised by hysteresis behaviour which is different in each case and is digitally programmed, with respect to the dependence on the path, for all determinable discrete distance positions whereby for a given number (DA 1) of half-waves counted by the counter (7, 107) the respective switch function is set to ON, and, for another number (DA2) differing from said number (DA 1), the switch function is set to OFF.

10. Proximity switch as claimed in Claim 7, characterised in that a coil (115) of the circuit component (111) supplies the operating voltage for an integrated circuit (114) in the circuit component (111) via an inductive coupling to the coil (LO) of the energising and evaluating stage, and the circuit (114) actively influences the jump response of the circuit component (111) in that it preferably short-circuits the coil (L1) after a given number of fade actions.

11. Proximity switch as claimed in Claim 10, characterised in that the circuit (114) contains an electrically programmable and erasable read-only memory in which a characteristic switching function can be stored for identifying the state of the circuit component.

## Revendications

1. Interrupteur de proximité fonctionnant sans contact, comportant
a) un circuit oscillant (L1,C1) présentant une excitation par sauts,
b) au moins un élément de commutation (11 ;111), qui influe sur le déroulement dans le temps d'au moins une réponse par sauts du circuit oscillant (L1,C1) en fonction de sa distance par rapport à une surface de détection (12) de l'interrupteur,
c) un circuit d'évaluation (1;101), qui détecte, dans au moins une réponse par sauts du circuit oscillant (L1,C1) à une telle excitation, au moins une grandeur caractéristique du déroulement dans le temps de l'oscillation amortie,
d) une source de tension de référence (6) produisant au moins un niveau de tension de référence (U_{ref}),
e) au moins un comparateur (5), qui compare l'amplitude de la réponse par sauts au niveau associé de tension de référence (U_{ref}),
f) au moins un compteur (7), qui compte, au moins pendant une partie du temps d'amortissement de la réponse par sauts, le nombre (DA) d'alternances de la réponse par sauts dont la valeur crête dépasse, par valeurs inférieures ou supérieures, le niveau associé de tension de référence (U_{ref}),
caractérisé en ce que
g) il est prévu au moins un second compteur (10) raccordé, comme le premier compteur (7), à la sortie du comparateur (5) et qui forme une grandeur numérique, qui correspond à la fréquence propre de la réponse par sauts, et h) la grandeur numérique, qui correspond à la fréquence propre de la réponse par sauts du circuit d'évaluation (1; 101) est soumise, conjointement avec la grandeur numérique, formée par le premier compteur (7) et qui correspond à la durée d'amortissement de la réponse par sauts, à une évaluation commune.

2. Interrupteur de proximité selon la revendication 1, caractérisé en ce que le second compteur (10) est raccordé à la sortie d'un circuit de porte (8), dont les deux entrées sont reliées à la sortie du comparateur (5) ou d'un générateur de cadence (9) stable en fréquences, dont la fréquence de répartition est supérieure à la fréquence propre de la réponse échelon.

3. Interrupteur de proximité selon la revendication 1 ou 2, caractérisé par un étage de commande (4) pour une excitation par sauts du circuit oscillant et une détermination des opérations de comptage du compteur (7,10) sur un nombre déterminé de réponses par sauts.

4. Interrupteur de proximité selon l'une des revendications 1 à 3, caractérisé en ce que l'élémentde commutation (11) est constitué par une plaquette métallique conductrice du point de vue magnétique et électrique, qui influe sur la fréquence propre (fₒ) et la constante de temps d'amortissement (i) de la réponse par sauts.

5. Interrupteur de proximité selon l'une des revendications 1 à 3, caractérisé en ce que l'élément de commutation est constitué par un matériau conducteur du point de vue électrique,mais pas du point de vue magnétique, qui influe essentiellement uniquement sur la constante de temps d'amortissement (_{T}) de la réponse par sauts.

6. Interrupteur de proximité selon l'une des revendications 1 à 3, caractérisé en ce que l'élément de commutation est constitué par une ferrite et influe essentiellement uniquement sur la fréquence propre (fₒ) de la réponse par sauts.

7. interrupteur de proximité selon l'une des revendications 1 à 3, caractérisé en ce que le circuit oscillant (L1,C1) est disposé dans l'élément de commutation (111) et que, pour l'excitation ainsi que la détection de la réponse par sauts, il est prévu une bobine (LO) située dans l'étage d'excitation et d'évaluation (101).

8. Interrupteur de proximité selon l'une des revendications 1 à 7, caractérisé par une mémoire numérique de l'étage d'excitation et d'évaluation (1;101) pour une correction des grandeurs numériques déterminées, au moyen d'une association tabulaire quelconque dans une mémoire.

9. Interrupteur de proximité selon l'une des revendications 1 à 8, caractérisé par un comportement d'hystérésis programmé numériquement en fonction de la distance et respectivement différent pour toutes les positions d'écartement discrètes détectables, grâce auquel, dans le cas d'un nombre déterminé (DA 1), compté par le compteur (7, 107), d'alternances, la fonction de commutation considérée est positionnée sur MARCHE et, dans le cas d'un autre nombre (DA 2) différent dudit nombre (DA 1), la fonction de commutation est positionnée sur ARRET.

10. Interrupteur de proximité selon la revendication 7, caractérisé en ce qu'une bobine (115) de l'élément de commutation (111) délivre, par l'intermédiaire d'un couplage inductif à la bobine (LO) de l'étage d'excitation et d'évaluation, la tension de service pour un circuit intégré (114) situé dans l'élément de commutation (111), et que le circuit (114) d'une manière active sur la réponse par sauts de l'élément de commutation (111) par le fait qu'il court-circuite de préférence la bobine (L1) au bout d'un nombre déterminé de processus d'amortissement.

11. Interrupteur de proximité selon la revendication 10, caractérisé en ce que le circuit (114) contient une mémoire morte programmable et effaçable électriquement, dans laquelle peut être mémorisée une fonction de commutation caractéristique servant à identifier l'état de l'élément de commutation.
